(19) Europäisches Patentamt
European Patent Office
Office européen des brevets

(11) **EP 4 577 028 A1**

(12) **EUROPEAN PATENT APPLICATION**

(43) Date of publication:
**25.06.2025 Bulletin 2025/26**

(21) Application number: 23219355.7

(22) Date of filing: **21.12.2023**

(51) International Patent Classification (IPC):
**H10N 69/00** (2023.01)     *G06N 10/40* (2022.01)

(52) Cooperative Patent Classification (CPC):
**H10N 69/00; H10D 1/692;** G06N 10/40

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **IST Austria - Institute of Science and Technology Austria**
**3400 Klosterneuburg (AT)**

(72) Inventors:
• **Zemlicka, Martin**
**3400 Klosterneuburg (AT)**
• **Fink, Johannes**
**3400 Klosterneuburg (AT)**

(74) Representative: **J A Kemp LLP**
**80 Turnmill Street**
**London EC1M 5QU (GB)**

(54) **QUBIT DEVICE**

(57)     Provided is a superconducting qubit comprising a capacitor and a Josephson junction connected to the capacitor. The capacitor comprises two opposing surfaces coated with a superconducting material. When the superconducting qubit is placed in a vacuum, a region between the opposing surfaces is evacuated. A configuration of the capacitor is such that an energy relaxation lifetime of the qubit is at least $100\mu s$. The capacitor may comprise two electrode structures comprising a dielectric material coated with a superconducting material, each opposing surface provided by a corresponding electrode structure. Three mutually perpendicular lines can be drawn through the dielectric material, each line intersecting the superconducting material on two opposing sides of the electrode structure.

Fig. 8

## Description

The present invention relates to designs of qubits for quantum computing, specifically superconducting qubits.

Quantum computers offer a revolution in certain types of computational tasks that are currently impossible or impractical using classical computers. Just as the basic unit of computation for a classical computer is a binary bit, the basic building unit of quantum information is the qubit. A qubit represents the quantum state of a two-level quantum mechanical system. Building a quantum computer requires devices that can store quantum states for timescales long enough to perform computations using the stored quantum information. Both the stored information itself and the devices used to store that information are often referred to as 'qubits'.

A wide variety of different approaches are under active investigation for use in quantum computing. These approaches need to balance the lifetime of the quantum state storage (qubit lifetime) with other considerations such as scalability.

Superconducting qubits represent a promising approach for scalability. They have the potential to be more easily mass produced by fabrication techniques similar to those used in the manufacture of classical semiconductor computing devices, such as optical or electron-beam lithography. However, current designs of superconducting qubit often have lifetimes shorter than those achievable with other types of qubit such as ion trap qubits.

A focus of development in superconducting qubits is therefore producing qubit architectures with improved lifetimes.

According to an aspect of the present disclosure, there is provided a superconducting qubit comprising a capacitor and a Josephson junction, wherein: the Josephson junction is connected to the capacitor; the capacitor comprises two opposing surfaces; the opposing surfaces are coated with a superconducting material; the capacitor is configured such that, when the superconducting qubit is placed in a vacuum, a region between the opposing surfaces is evacuated; and a configuration of the capacitor is such that an energy relaxation lifetime of the qubit is at least $100\mu$s.

This design provides a transmon-type qubit where the capacitor has a vacuum between the two capacitor plates. This capacitor configuration ensures that the electric field energy of the capacitor is stored in vacuum, rather than in the dielectric substrate on which the capacitor is typically deposited in existing designs. This reduces coupling of the electric field to impurities in the substrate, thereby increasing the energy relaxation lifetime of the qubit. Using this design, lifetimes exceeding $100\mu$s are achievable.

Optionally, the capacitor comprises two electrode structures; each opposing surface is provided by a corresponding one of the electrode structures; each electrode structure comprises a dielectric material coated with the superconducting material, optionally wherein the dielectric material comprises silicon; and the configuration of the capacitor comprises a configuration of the coating of the dielectric material with the superconducting material. By carefully choosing how the dielectric substrate is pre-shaped and how the superconducting material coats the dielectric substrate, the interaction of the electric field of the capacitor with the dielectric substrate can be minimised. This allows the energy relaxation lifetime to be improved relative to existing designs.

Optionally, the configuration of the coating of the dielectric material with the superconducting material is such that three mutually perpendicular lines can be drawn through the dielectric material, each line intersecting the superconducting material on two opposing sides of the electrode structure. In this configuration, the dielectric supporting the capacitor electrodes is effectively coated all over with superconducting material, thereby maximising the proportion of the electric field that is stored in vacuum rather than in the dielectric substrate.

Optionally, the configuration of the capacitor comprises one or more of: an area of the opposing surfaces; a separation of the opposing surfaces; a surface roughness of the opposing surfaces; and a proportion of the energy stored by the capacitor that is stored in vacuum when the superconducting qubit is placed in the vacuum. These parameters can all be adjusted to maximise the energy relaxation lifetime of the qubit.

Optionally, the capacitor is configured such that, when the superconducting qubit is placed in a vacuum, at least 50% of the energy stored by the capacitor is stored in the vacuum, optionally at least 70 %, optionally at least 90%, optionally at least 95%. This reduces coupling of the electric field to impurities in the substrate, thereby increasing the energy relaxation lifetime of the qubit.

Optionally, the Josephson junction is provided on a junction region of a substrate, and the dielectric material of each electrode structure is provided by a corresponding electrode region of the substrate. This separation of the Josephson junction and capacitor structure makes it more straightforward to design the capacitor parameters as required to maximise the energy relaxation lifetime of the overall qubit.

Optionally, the capacitor is configured such that energy loss due to interaction of an electric field of the capacitor with the substrate contributes at most 50% of total energy losses that determine the energy relaxation lifetime of the qubit, optionally at most 30%, optionally at most 10%, optionally at most 5%. By minimising the losses due to substrate interaction, the lifetime of the qubit can be greatly increased.

Optionally, the junction region is connected to the electrode regions via a plurality of connecting regions, and the energy participation ratio at the connecting regions is at most 10%, optionally at most 5%, optionally at most 2%, optionally at most 1%, the energy participation ratio being a ratio of energy stored in the substrate due to the electric field of the capacitor to the total capacitor energy. In the connecting regions it is less convenient to use the superconducting coating around all three axes to force the electric field to be stored in vacuum rather than in the dielectric material, due to the other structures present. Minimising the electric field energy in this region thereby further reduces the interaction of the capacitor field with the substrate to further reduce losses.

Optionally, a thickness of the substrate in the junction region is within 10% of a thickness of the substrate in the electrode regions, optionally within 5%. Keeping the thickness of the substrate relatively uniform simplifies manufacturing of the devices and increases mechanical stability.

Optionally, a) the opposing surfaces are substantially flat and optionally parallel to one another; b) a separation of the opposing surfaces is at least 100μm; and c) a surface roughness of the opposing surfaces is at most 50nm. These parameters have all been found to contribute to improved manufacturability and increased energy relaxation lifetime.

Optionally, the capacitor comprises two electrode structures; each opposing surface is provided by a corresponding one of the electrode structures; and the configuration of the capacitor comprises a size and/or a shape of the electrode structures. The size and shape of the electrode structures affects the distribution of the electric field of the capacitor, and is therefore an important factor in the design to minimise the interaction of the electric field with the substrate. Optionally, a smallest linear extent of the electrode structures is at least 50μm.

Optionally, a surface roughness of the opposing surfaces is less than a thickness of the superconducting material, optionally wherein the surface roughness is at most 20% of the thickness of the superconducting material, optionally at most 10%, optionally at most 5%, optionally at most 2%. This improves the uniformity of the electric field distribution in the vacuum gap.

Optionally, a) a capacitance of the capacitor is at least 10fF, optionally at least 20fF, optionally at least 50fF; and/or b) a capacitance of the capacitor is at most 200fF, optionally at most 100fF. These capacitance values are most appropriate for a transmon qubit to reduce charge noise.

Optionally, the superconducting material comprises aluminium, niobium, tantalum, titanium nitride or niobium titanium nitride. These materials have good superconducting properties that help to enhance the energy relaxation lifetime of the device.

Optionally, a thickness of the superconducting material is greater than the London penetration depth of the superconducting material, optionally at least 50% greater. This ensures the superconducting behaviour of the material is consistent and predictable over the device and reduces magnetic losses in the superconductor.

According to another aspect of the invention, there is provided a superconducting qubit comprising a Josephson junction and a capacitor, wherein: the Josephson junction is connected to the capacitor; the capacitor comprises two electrode structures; the capacitor comprises two opposing surfaces, each opposing surface provided by a corresponding one of the electrode structures; the capacitor is configured such that, when the superconducting qubit is placed in a vacuum, a region between the opposing surfaces is evacuated; and each electrode structure comprises a dielectric material coated with a superconducting material such that: the opposing surfaces are coated with the superconducting material; and three mutually perpendicular lines can be drawn through the dielectric material, each line intersecting the superconducting material on two opposing sides of the electrode.

In this configuration, the dielectric supporting the capacitor electrodes is effectively coated all over with superconducting material, thereby maximising the proportion of the electric field that is stored in vacuum rather than in the dielectric substrate.

Optionally, a configuration of the capacitor is such that an energy relaxation lifetime of the qubit is at least 100μs, optionally at least 200μs, optionally at least 500μs, optionally at least 1ms, optionally at least 2ms, optionally at least 4ms. These times are sufficiently long to permit useful quantum computation and sensitive quantum sensing using the qubit device.

Embodiments of the invention will now be described, by way of example only, with reference to the accompanying drawings in which corresponding reference symbols represent corresponding parts, and in which:

Fig. 1 is a circuit diagram of a transmon qubit;
Fig. 2 shows a typical prior art transmon qubit design;
Fig. 3 is a further view of the qubit of Fig. 2;
Fig. 4 is a further view of the qubit of Fig. 2;
Fig. 5 shows the distribution of the electric field energy density around the qubit of Fig. 2;
Fig. 6 is an expanded view of the central region of Fig. 5 showing also the distribution of the electric field in the dielectric substrate;
Fig. 7 is a further expanded view of the central region of Fig. 5;
Fig. 8 is a perspective view of a qubit design according to the present disclosure;
Fig. 9 is a plan view of the qubit of Fig. 8;
Fig. 10 shows the distribution of the electric field energy density around the qubit of Fig. 8;

Fig. 11 is an expanded view of the central region of Fig. 10;

Fig. 12 is a further expanded view of the central region of Fig. 10;

Fig. 13 shows the dimensions and component capacitances of the capacitor of an alternative qubit design according to the present disclosure;

Fig. 14 shows an example of suitable capacitor dimensions of a qubit design according to the present disclosure;

Fig. 15 is a graph of the predicted energy relaxation lifetime as a function of capacitor width for a qubit according to the present disclosure, where the capacitor gap is $200\mu$m; and

Fig. 16 is a graph of the predicted energy relaxation lifetime as a function of capacitor width for a qubit according to the present disclosure, where the capacitor gap is $500\mu$m.

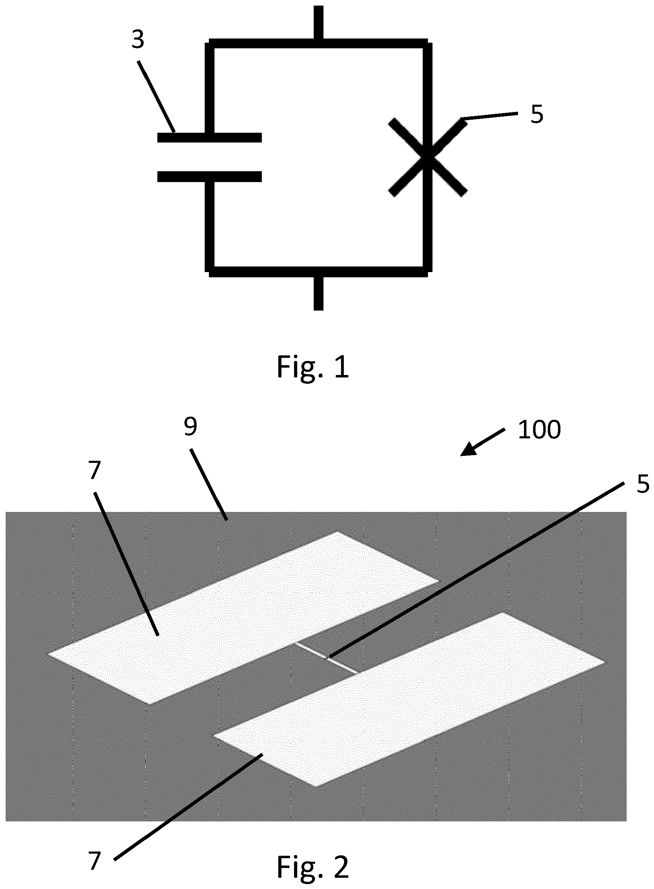

Fig. 1 shows a circuit diagram of a transmon qubit. A transmon qubit is a common archetype of superconducting charge qubit. A charge qubit comprises a Josephson junction connected in parallel with a capacitor. In a transmon qubit, the size of the capacitor is increased such that the capacitor charging energy is small relative to the Josephson energy of the junction. This reduces noise from charge fluctuations on the capacitor. State of the art transmon qubits can reach energy relaxation lifetimes (also commonly referred to as $T_1$ time) of $500\mu$s.

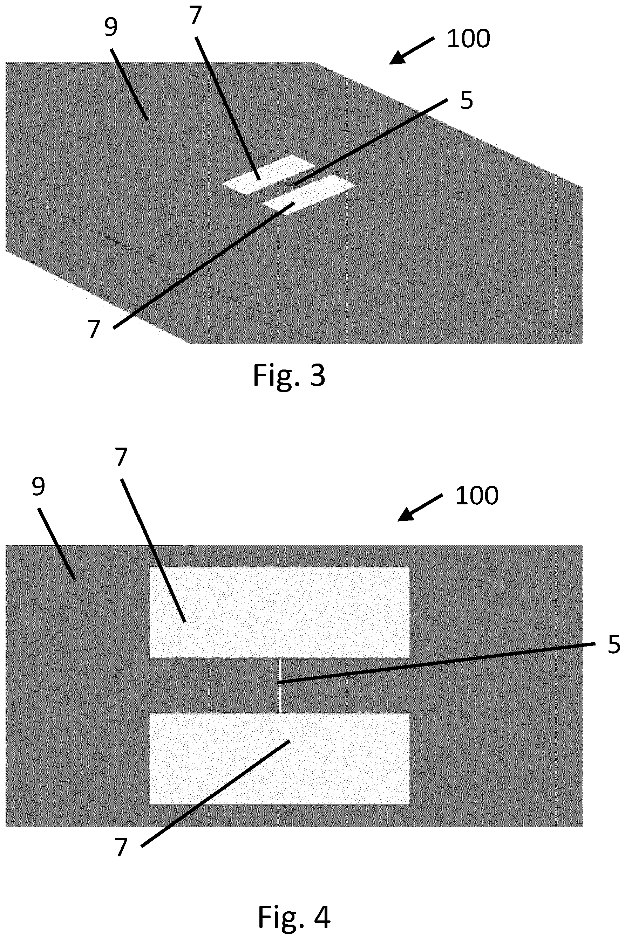

Fig. 2, Fig. 3, and Fig. 4 show different views of a typical prior art design of transmon qubit 100. The Josephson junction 5 is connected between two electrodes 7 made of a superconducting material such as aluminium. The electrodes 7 form the capacitor 3, and are usually capacitively coupled to one or more readout lines (not shown in Fig. 2) for processing operations and measurement. Alternatively, the qubit 1 may be placed in a resonant cavity to permit coupling to readout lines via the resonant modes of the cavity. The Josephson junction 3 and electrodes 7 are formed by lithography on a dielectric substrate 9, for example silicon.

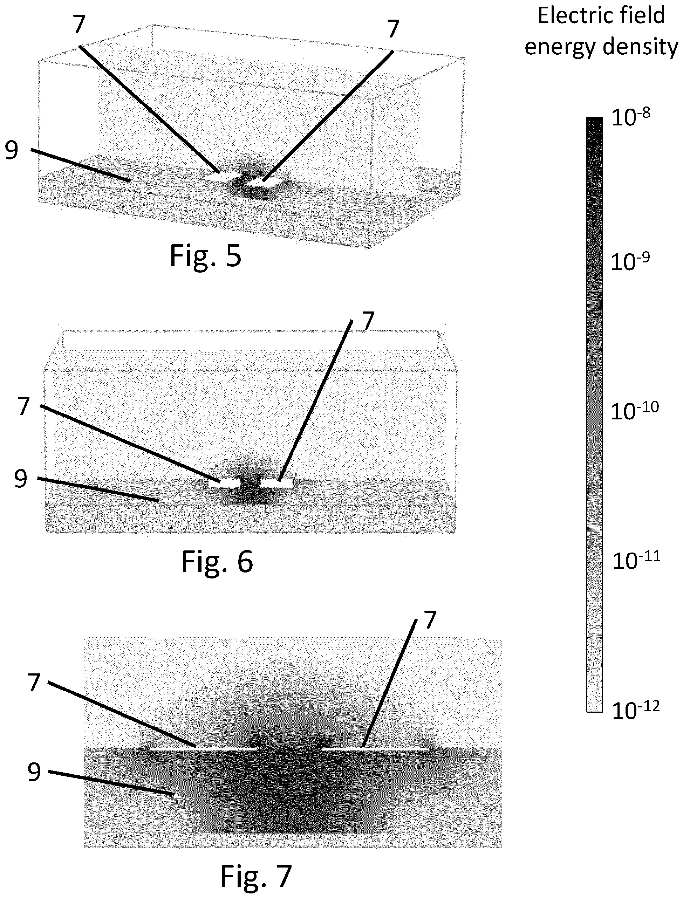

Fig. 5, Fig. 6, and Fig. 7 show simulations of the electric field energy density around the capacitor 3 in the prior art design of Fig. 2 on a logarithmic scale. The scale shown on the right of these figures applies to all of Fig. 5, Fig. 6, and Fig. 7.

Fig. 7 in particular demonstrates that the electric field is strongest within the substrate between the electrodes 7. Typically, more than 90% of the energy stored by the electric field of the capacitor is stored in the dielectric substrate in a qubit of this design. This is due in particular to the higher permittivity of the substrate compared to the vacuum above it.

This type of design has an energy relaxation lifetime that is strongly limited by losses in the material interfaces and the surface of the dielectric. This is due, for example, to coupling of the capacitor electric field to surface impurities that form parasitic two-level systems, as well as bulk losses in the substrate.

The present inventors have therefore recognised that an effective strategy to improve the energy relaxation lifetimes of transmon-type qubits would be to reduce the energy of the capacitor electric field stored in the substrate. However, shifting some of the electric field into vacuum may not alone be sufficient to significantly improve $T_1$ times.

A previous approach [Zemlicka2022] used thin nanomembranes to store the electric energy of the capacitor in vacuum. However, this device was designed to provide a selective probe for investigating superconductor surface losses, and was not intended to provide a high coherence qubit. The configuration of the capacitor in that device, for example the small dimensions of the capacitor gap, caused the $T_1$ time to be limited to less than $5\mu$s due to losses on the superconductor surface.

In contrast, the present disclosure demonstrates that by using a capacitor design with a vacuum gap, the configuration of the capacitor can be engineered to provide energy relaxation lifetimes exceeding $100\mu$s, and possibly exceeding the highest $T_1$ times of state of the art transmon designs. In order to use a vacuum gap capacitor to usefully increase the qubit $T_1$ lifetime, the electric field strength per unit qubit area is reduced while maintaining generally similar other qubit parameters.

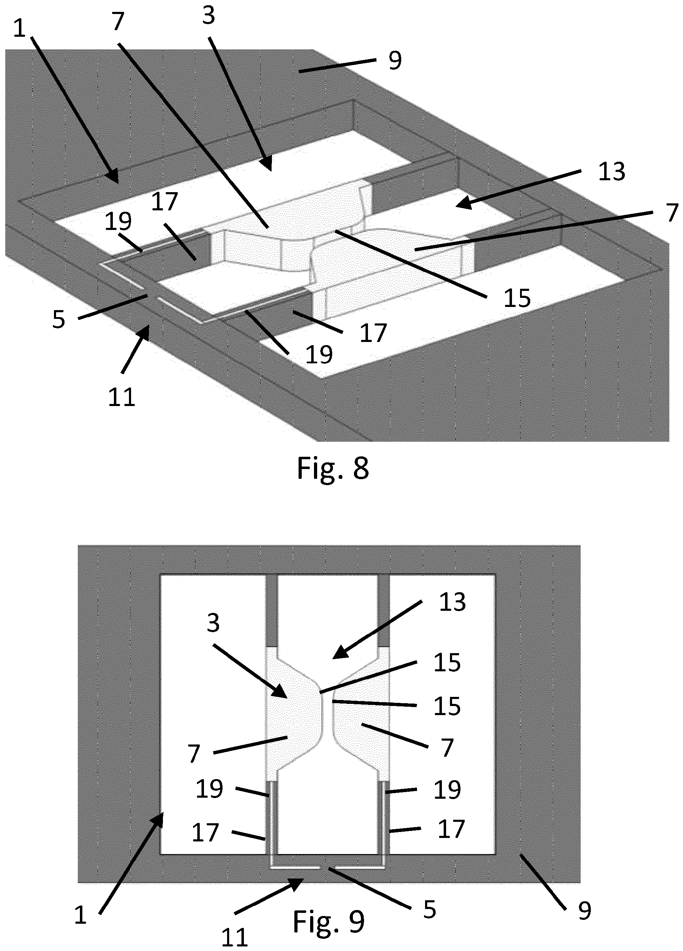

Fig. 8 and Fig. 9 show an exemplary design of superconducting qubit 1 according to the present invention. The superconducting qubit 1 comprises a capacitor 3 and a Josephson junction 5.

The Josephson junction 5 comprises two superconducting regions coupled together by a weak link that allows Cooper pairs to quantum tunnel between the two superconducting regions. A common type of Josephson junction 5 comprises two aluminium regions separated by a layer of aluminium oxide. This design can be fabricated relatively easily using two deposition steps to deposit overlapping aluminium layers by shadow evaporation. The deposition steps are separated by an oxidation step in which oxygen is introduced to the vacuum chamber in which the deposition occurs, so that a thin layer of aluminium oxide forms on top of the first layer before the second layer is deposited on top. Of course, this fabrication method is not essential, and any suitable method may be used to form the Josephson junction 5 using any suitable materials for the superconducting regions and the link between them. For example, it is also possible to form Josephson junctions 5 using overlapping niobium layers separated by an aluminium oxide layer. This may be used, for example, where a junction is required that can function in relatively high magnetic fields, due to the higher critical magnetic field of niobium compared to aluminium.

The Josephson junction 5 is provided on a junction region 11 of a substrate 9. A thickness of the substrate 9 is not particularly limited. The thickness may be chosen to provide good mechanical stability and to make the qubit easily to handle and integrate into larger devices and systems. There is no practical lower limit on the thickness as long as the substrate provides acceptable mechanical stability. For example, the thickness may be at least $50\mu$m, optionally at least $100\mu$m, optionally at least $200\mu$m. There is no upper limit on the thickness other than that imposed by the availability of materials and the practicality of manufacture and integration of the qubit 1 into larger systems. For example, the thickness may be at most 2mm, optionally at most 1mm, optionally at most $700\mu$m. For example, the thickness may be $500\mu$m.

A material of the substrate 9 may comprise any suitable material. The material may be chosen for ease of manufacture and integration with lithographic processes used to form the Josephson junction 5 and capacitor 3. For example, the substrate 9 may comprise a dielectric material such as silicon.

The superconducting qubit 1 further comprises a capacitor 3. The qubit 1 is generally of the transmon type, and so a capacitance of the capacitor 3 may be at least 10fF, optionally at least 20fF, optionally at least 50fF. The capacitance of the capacitor 3 may be at most 200fF, optionally at most 100fF. If the capacitance of the capacitor 3 is lower than 10fF, for example approximately 1fF, then the charging energy of the capacitor 3 may be similar to or larger than the Josephson energy of the Josephson junction 5. This would mean the qubit 1 is no longer a transmon qubit. This is possible, although not usually preferred due to the greater charge noise experienced by charge qubits in this regime.

The capacitor 3 comprises two opposing surfaces 15. The opposing surfaces 15 are coated with a superconducting material. The superconducting coatings on the opposing surfaces 15 provide the electrodes of the capacitor. Any suitable superconducting material may be used. Suitable examples include aluminium, niobium, tantalum, and niobium titanium nitride. Materials such as tantalum (Ta) or niobium titanium nitride (NbTiN) have lower surface losses than other materials such as aluminium, which can help to further improve the energy relaxation lifetime of the qubit 1.

The capacitor 3 is configured such that, when the superconducting qubit 1 is placed in a vacuum, a region between the opposing surfaces 15 is evacuated. This means that the capacitor 3 is a vacuum-gap capacitor. As discussed above, using a vacuum-gap capacitor means that the interaction of the electric field of the capacitor 3 with the dielectric substrate of the qubit 1 is reduced, thereby reducing losses.

The capacitor 3 comprises two electrode structures 7, and each opposing surface 15 is provided by a corresponding one of the electrode structures 7. Each electrode structure 7 comprises a dielectric material coated with the superconducting material that provides the corresponding electrode. The coating of the opposing surfaces 15 is provided by a portion of the coating of the corresponding electrode structure 7. The dielectric material of each electrode structure 7 is provided by a corresponding electrode region 13 of the substrate 9. As mentioned above in connection with the substrate 9, the dielectric material may comprise any suitable material, for example silicon. A thickness of the substrate 9 in the junction region 11 is preferably within 10% of a thickness of the substrate 9 in the electrode regions 11, optionally within 5%. This uniformity of thickness increases the ease of manufacturing because no special process is required to adjust the substrate thickness in different regions of the qubit 1.

A thickness of the superconducting material coating the electrode structures 7 (and thereby the opposing surfaces 15) is preferably greater than the London penetration depth of the superconducting material, optionally at least 50% greater. Using a thickness below the London penetration depth is possible, but at such thicknesses a magnetic field could penetrate the superconductor. Such penetration could lead to additional magnetic losses that may reduce the $T_1$ lifetime of the qubit 1. However, if the qubit 1 is properly shielded from magnetic fields, a thickness below the London penetration depth may not be problematic. The thickness of the superconducting material may be at least 10nm, optionally at least 50nm, optionally at least 100nm. An appropriate thickness can be verified for a specific material by fabricating high quality factor (Q) resonators to determine a thickness at which the Q of the resonator is not limited by the superconducting material thickness.

The Josephson junction 5 is connected to the capacitor 3. The junction region 11 of the substrate 9 is connected to the electrode regions 13 via a plurality of connecting regions 17. The connecting regions 17 may comprise corresponding leads 19 of superconducting material that connect the capacitor 3 to the Josephson junction 5.

In combination with the use of a vacuum gap capacitor 3, a configuration of the capacitor 3 is such that an energy relaxation lifetime of the qubit 1 is at least $100\mu$s. Optionally, the energy relaxation lifetime of the qubit 1 is at least $200\mu$s, optionally at least $500\mu$s, optionally at least 1ms. There are a number of ways in which the configuration of the capacitor 3 can be designed to achieve this performance.

The configuration of the capacitor 3 that is designed to achieve the specified lifetime may comprise a configuration of the coating of the dielectric material with the superconducting material.

Generally speaking, the advantage obtained by coating a particular portion of the dielectric material of the electrode structure scales with the strength of the electric field at that portion of the dielectric material. This is because coating the dielectric focuses and directs the electric field to the vacuum instead of the dielectric substrate. The stronger the electric field at that point, the greater the proportion of the stored energy of the capacitor that is moved into the vacuum and therefore prevented from interacting with the dielectric material.

The configuration of the capacitor 3 may further comprise a proportion of the energy stored by the capacitor 3 that is stored in vacuum when the superconducting qubit 1 is placed in the vacuum. The capacitor 3 may be configured such that, when the superconducting qubit 1 is placed in a vacuum, at least 50% of the energy stored by the capacitor 3 is stored in the vacuum, optionally at least 70%, optionally at least 90%, optionally at least 95%. The effective relative permittivity experienced by the capacitor 3 may be at most 5, optionally at most 2, optionally at most 1.5, optionally at most 1.1.

The capacitor 3 may be configured such that energy loss due to interaction of an electric field of the capacitor 3 with the substrate contributes at most 50% of total energy losses that determine the energy relaxation lifetime of the qubit 1, optionally at most 30%, optionally at most 10%, optionally at most 5%.

Another way to shift more of the electric field into the vacuum is to use suspended electrode structures 7 surrounded by vacuum, where the superconducting material wraps around the dielectric of the electrode structure 7. In this design, the configuration of the coating of the dielectric material of the electrode structures 7 with the superconducting material is such that three mutually perpendicular lines can be drawn through the dielectric material, each line intersecting the superconducting material on two opposing sides of the electrode structure 7. The opposing sides are optionally parallel, but this is not essential. Each of the mutually perpendicular lines passes through the superconducting material at two separate intersection points, while passing through the dielectric material between the two intersection points. The lines may pass through only the dielectric material and the superconducting material between the two intersection points.

This "wrapping around" of the superconducting material means that the electric field has topologically no other option than to be in the vacuum around the electrode structure 7. If the dielectric material of the electrode structures 7 is not covered with superconducting material on all sides, the electric field of the capacitor 3 will tend to prefer a path in the dielectric, which typically has an order of magnitude higher permittivity. This would mean that most of the electric energy is stored in the dielectric where it can dissipate due to impurities.

In practice, it is not possible for the electrode structure 7 to be completely isolated from the surrounding structure and covered all around, because the electrode structures 7 must be mechanically attached to the rest of the structure of the qubit 1. This is achieved by the narrow beams of the connecting regions 17, which are not coated in superconducting material. However, the configuration of the capacitor 3 is preferably designed to minimize the effect of the connection regions 17. The energy participation ratio at the connecting regions 17 is at most 10%, optionally at most 5%, optionally at most 2%, optionally at most 1%. The energy participation ratio in this context is a ratio of energy stored in the substrate 9 due to the electric field of the capacitor 3 to the total capacitor energy. In other words, the electric field in the substrate 9 in the connecting regions 17 stores at most 10% of the total energy stored by the capacitor 3. This can be achieved in part by configuring the capacitor 3 such that the electric field strength from the capacitor 3 at the connecting regions 17 is much lower than the electric field strength from the capacitor 3 at its maximum between the opposing surfaces. For example, the electric field strength due to the capacitor 3 at the connecting regions 17 may be at most 5% of a maximum electric field strength of the capacitor 3, optionally at most 2%, optionally at most 1%.

A thinner substrate 9 in the connecting regions 17 can provide an improvement in the vacuum distribution of the electric field, because there is physically less substrate 9 for the electric field to couple to where the substrate 9 is not coated with superconducting material as it is at the electrode structures 7. This can be a reason to limit the thickness of the substrate 9, for example to at most $500\mu m$ or at most $200\mu m$.

As well as the coating of the dielectric material, the configuration of the capacitor 3 designed such that the energy relaxation lifetime of the qubit is at least $100\mu s$ may comprise a size and/or a shape of the electrode structures 7. For example, a smallest linear extent of the electrode structures 7 may be at least $50\mu m$, optionally at least $100\mu m$.

The configuration of the capacitor 3 may further comprise an area of the opposing surfaces 15. The area of each of the opposing surfaces 15 may be in the range $0.01mm^2$ to $2mm^2$, optionally in the range $0.1mm^2$ to $0.5mm^2$.

The configuration of the capacitor 3 may further comprise a separation of the opposing surfaces 15. The separation of the opposing surfaces 15 may be at least $100\mu m$. The separation of the opposing surfaces 15 may be at most 1mm. For example, the separation of the opposing surfaces may be approximately $500\mu m$. The separation may vary by at most 20%, optionally at most 10%, optionally at most 5%, optionally at most 2% over the opposing surfaces 15. The separation of the opposing surfaces 15 may be substantially constant over the entirety of the opposing surfaces 15.

The opposing surfaces 15 face one another, such that a line normal to one of the opposing surfaces 15 passes through the other of the opposing surfaces 15. The opposing surfaces 15 may be substantially flat and may be substantially parallel to one another.

The configuration of the capacitor 3 may further comprise a surface roughness of the opposing surfaces 15. A surface roughness of the opposing surfaces 15 may be at most 50nm, optionally at most 20nm, optionally at most 10nm. Preferably, a surface roughness of the opposing surfaces 15 is less than a thickness of the superconducting material. Optionally, the surface roughness is at most 20% of the thickness of the superconducting material, optionally at most 10%, optionally at most 5%, optionally at most 2%, optionally at most 1%.

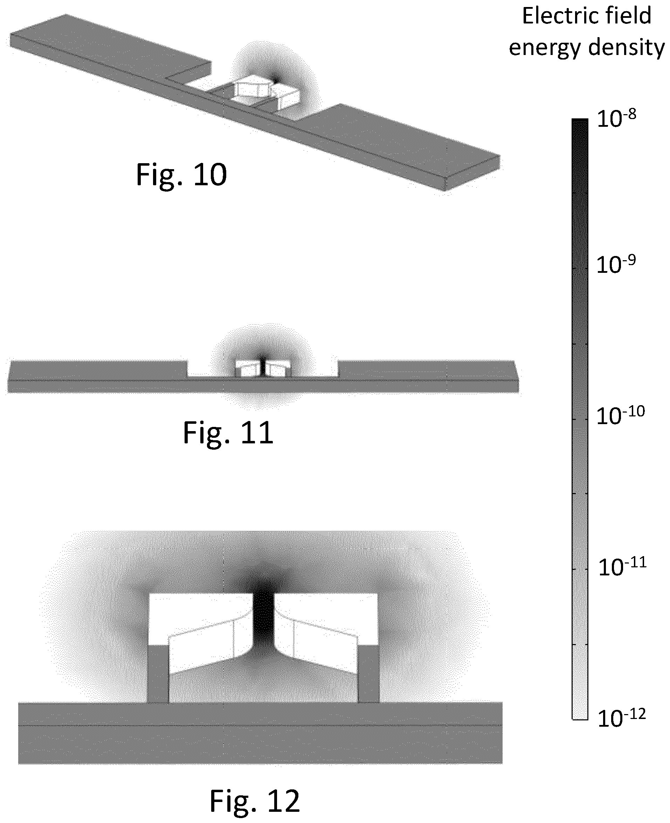

Fig. 10, Fig. 11, and Fig. 12 show the simulated electric field energy density distribution around the capacitor 3 of the qubit of Fig. 8 and Fig. 9 on a logarithmic scale. The scale shown on the right of these figures applies to all of Fig. 10, Fig. 11, and Fig. 12.

These figures demonstrate that the present design has the regions of highest electric field strength in the vacuum between the opposing surfaces 15. The electric field strength is much lower at the regions of dielectric substrate 9 that are not coated with superconducting material to form the electrode structures 7. This means that the coupling of the capacitor 3 to the dielectric substrate 9 is greatly reduced.

To determine the minimum qubit size that ensures a specified minimum qubit $T_1$ lifetime (energy relaxation time), the dependence of the $T_1$ lifetime on the qubit capacitor 3 size can be modelled. An exemplary threshold of 1ms for the minimum qubit lifetime was chosen for the following calculations.

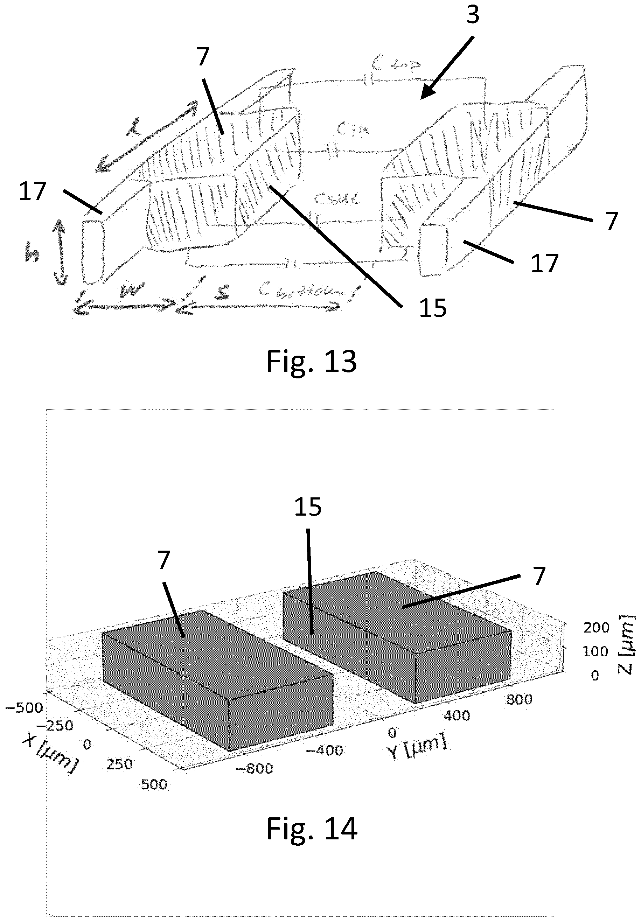

For simplicity of modelling, a rectangular shape for the electrode structures 7 is used for the model, as shown in Fig. 13. This is in contrast to the slightly trapezoidal shape of electrode structure 7 shown in Fig. 8 to Fig. 12. The slightly trapezoidal shape may be preferred in practice because it is somewhat easier to fabricate as the shape simplifies the surface coverage with the superconducting material.

The model neglects the contribution of the connecting regions 17, because previous numerical simulations (such as those shown in Fig. 10, Fig. 11, and Fig. 12) have shown the impact of the connecting regions 17 on qubit losses to be negligible.

The vertical dimension (h) of the qubit 1 is determined by the thickness of the substrate 9. For the purpose of this example, a thickness of 200$\mu$m is used, which corresponds to the thickness of a standard, commercially-available silicon substrate.

The horizontal dimension (l) of the capacitor 3 is determined by the surface area of the capacitor electrodes and the capacitor gap (s), i.e. the separation of the opposing surfaces 15. A suitable example value for the capacitor gap is 500$\mu$m. This permits the use of angled deposition at 20 degrees for high-quality side metallization of the electrode structures 7 without creating shadowing issues. Numerical calculations as well as simulations such as those in Fig. 10, Fig. 11, and Fig. 12 also show that reducing the capacitor gap further may lead to losses due to coupling to the impurities on the metal surface (metal-air interface) in the inner part of the capacitor 3 that reduce the qubit $T_1$ lifetime.

Given a fixed capacitor gap (s), the horizontal dimension (l) is defined by the desired capacitance, which must fall within the transmon range. A typical value of C = 20 fF is assumed. The total qubit capacitance will be further increased due to stray capacitance to the readout cavity, while the qubit anharmonicity remains in the transmon limit.

The total transmon capacitance of the exemplary capacitor design can be modelled as the sum of the parallel plate capacitor between the two opposing surfaces 15 ($C_{in}$), the two planar capacitors formed between the top and bottom surfaces of the electrode structures 7 ($C_{top}$ and $C_{bottom}$), and the two planar capacitors formed between the side surfaces of the electrode structures 7 ($C_{side}$). The capacitance between the two outer metallized surfaces is not included, because it is assumed to be negligible due to the small contribution of the electric field. This assumption has been confirmed by numerical electromagnetic simulations in COMSOL. Parallel combination of all the capacitances arrives at the following formula for the total capacitance:

$$C_{total} = \epsilon_0 l \left( \frac{h}{s} + \frac{K(k')}{K(k)} \right) + \epsilon_0 h \frac{K(k')}{K(k)}$$

where $K(k)$ is the total elliptic integral of the first kind, $k$ is the modulus of the elliptic integral, $k' = \sqrt{1 - k^2}$, and $\varepsilon_0$ is the permittivity of free space.

For a specific capacitor gap size (e.g. 500$\mu$m), the width (w) and length (l) of the capacitor electrodes are mutually dependent to satisfy the C = 20 fF transmon capacitance condition. Consequently, the width of the capacitor electrode determines the total qubit size. Using the specific capacitor geometry, the surface participation ratio of the electric field can be calculated normalized to the parasitic (lossy) layer thickness [Wang2015, Gambetta2017, Zemlicka2022]. This lossy layer determines the limit of energy dissipation in the qubit capacitor 3 and therefore the energy relaxation time $T_1$. Using the analytical analysis of the electric field in planar capacitors [Murray2018], a formula can be derived that describes the dependence of the surface sensitivity on the geometry of the invented capacitor design.

$$S_{MA} = \frac{1}{4} \frac{b^2}{K(k)K(k')} \int_a^b dx\, f(x + iy) f^*(x - iy) \frac{C_{top} + C_{side}}{C_{total}} + \frac{1}{s} \frac{C_{in}}{C_{total}}$$

where

$$f(x + iy) = 1/(\sqrt{((x + iy)^2 - a^2)((x + iy)^2 - b^2)})$$

$$a = \frac{s}{2}$$

$$b = \frac{s}{2} + w$$

Once $S_{MA}$ has been calculated, the qubit quality factor can also be calculated using $S_{MA}$ and the metal surface loss tangent value obtained from selective surface loss probing (Zemlicka2022). The qubit quality factor is the product of the qubit lifetime $T_1$ and the qubit angular frequency, so this can be used to estimate the qubit lifetime $T_1$ as a function of the capacitor electrode width (w) for a specific capacitor gap (s).

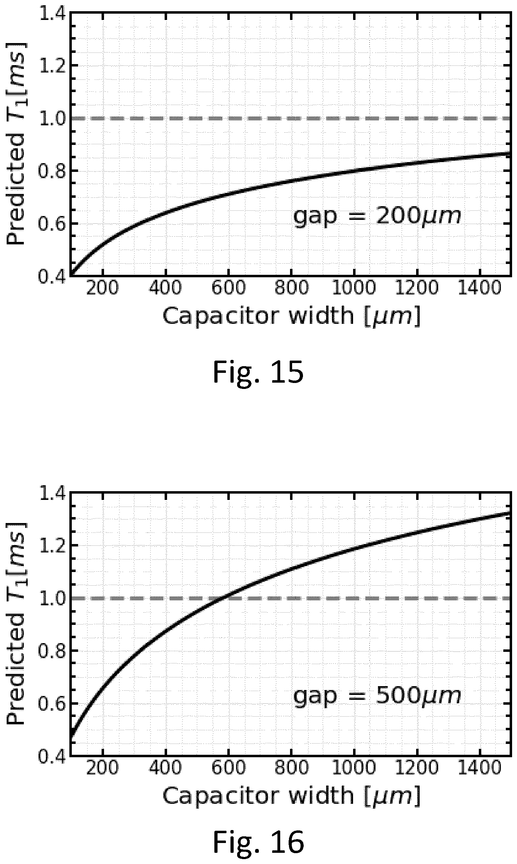

Example calculations are shown in Fig. 15 (for a gap of 200 $\mu$m) and in Fig. 16 (for a gap of 500 $\mu$m). To achieve a $T_1$ of at least 1ms for a 200 $\mu$m gap, the electrode width would need to be very large (w $\approx$ 4 mm) compared to the other qubit dimensions. This risks introducing mechanical instability to the qubit capacitor 3. For a 500 $\mu$m gap, a reasonable dimension for the electrode width (w $\approx$ 600 $\mu$m) is already enough to achieve the desired $T_1$. Using the formula for the total qubit capacitance $C_{total}$, the length of the electrode is determined to be l = 942 $\mu$m. A simplified, scale drawing of the capacitor electrodes having these dimensions is shown in Fig. 14.

REFERENCES

Zemlicka2022: Compact vacuum gap transmon qubits: Selective and sensitive probes for superconductor surface losses, (doi: 10.48550/arXiv.2206.14104)

Wang2022: Wang, C., Li, X., Xu, H. et al. Towards practical quantum computers: transmon qubit with a lifetime approaching 0.5 milliseconds. npj Quantum Inf 8, 3 (2022) (doi: 10.103 8/s41534-021-00510-2)

Wang2015: Surface participation and dielectric loss in superconducting qubits, (doi: 10.1063/1.4934486)

Gambetta2017: Investigating Surface Loss Effects in Superconducting Transmon Qubits, (doi: 10.1109/TASC.2016.2629670)

Murray2018: Analytical Determination of Participation in Superconducting Coplanar Architectures (doi: 10.1109/TMTT.2018.2841829)

**Claims**

1. A superconducting qubit comprising a capacitor and a Josephson junction, wherein:

   the Josephson junction is connected to the capacitor;
   the capacitor comprises two opposing surfaces;
   the opposing surfaces are coated with a superconducting material;
   the capacitor is configured such that, when the superconducting qubit is placed in a vacuum, a region between the opposing surfaces is evacuated; and
   a configuration of the capacitor is such that an energy relaxation lifetime of the qubit is at least 100 $\mu$s.

2. The superconducting qubit of claim 1, wherein:

   the capacitor comprises two electrode structures;
   each opposing surface is provided by a corresponding one of the electrode structures;
   each electrode structure comprises a dielectric material coated with the superconducting material, optionally wherein the dielectric material comprises silicon; and
   the configuration of the capacitor comprises a configuration of the coating of the dielectric material with the superconducting material.

3. The superconducting qubit of claim 2, wherein the configuration of the coating of the dielectric material with the superconducting material is such that three mutually perpendicular lines can be drawn through the dielectric material, each line intersecting the superconducting material on two opposing sides of the electrode structure.

4. The superconducting qubit of any preceding claim, wherein the configuration of the capacitor comprises one or more of:

an area of the opposing surfaces;
a separation of the opposing surfaces;
a surface roughness of the opposing surfaces; and
a proportion of the energy stored by the capacitor that is stored in vacuum when the superconducting qubit is placed in the vacuum.

5. The superconducting qubit of any preceding claim, wherein the capacitor is configured such that, when the superconducting qubit is placed in a vacuum, at least 80% of the energy stored by the capacitor is stored in the vacuum, optionally at least 90%, optionally at least 95%.

6. The superconducting qubit of any preceding claim, wherein the Josephson junction is provided on a junction region of a substrate, and the dielectric material of each electrode structure is provided by a corresponding electrode region of the substrate,
optionally wherein the capacitor is configured such that energy loss due to interaction of an electric field of the capacitor with the substrate contributes at most 20% of total energy losses that determine the energy relaxation lifetime of the qubit, optionally at most 10%, optionally at most 5%.

7. The superconducting qubit of claim 6, wherein the junction region is connected to the electrode regions via a plurality of connecting regions, and the energy participation ratio at the connecting regions is at most 10%, optionally at most 5%, optionally at most 2%, optionally at most 1%, the energy participation ratio being a ratio of energy stored in the substrate due to the electric field of the capacitor to the total capacitor energy.

8. The superconducting qubit of claim 6 or 7, wherein a thickness of the substrate in the junction region is within 10% of a thickness of the substrate in the electrode regions, optionally within 5%.

9. The superconducting qubit of any preceding claim, wherein one or more of:

a) the opposing surfaces are substantially flat and optionally parallel to one another;
b) a separation of the opposing surfaces is at least $100\mu$m; and
c) a surface roughness of the opposing surfaces is at most 50nm.

10. The superconducting qubit of any preceding claim, wherein:

the capacitor comprises two electrode structures;
each opposing surface is provided by a corresponding one of the electrode structures; and
the configuration of the capacitor comprises a size and/or a shape of the electrode structures,
optionally wherein a smallest linear extent of the electrode structures is at least $50\mu$m.

11. The superconducting qubit of any preceding claim, wherein a surface roughness of the opposing surfaces is less than a thickness of the superconducting material, optionally wherein the surface roughness is at most 20% of the thickness of the superconducting material, optionally at most 10%, optionally at most 5%, optionally at most 2%.

12. The superconducting qubit of any preceding claim, wherein:

a) a capacitance of the capacitor is at least 10fF, optionally at least 20fF, optionally at least 50fF; and/or
b) a capacitance of the capacitor is at most 200fF, optionally at most 100fF.

13. The superconducting qubit of any preceding claim, wherein:

a) the superconducting material comprises aluminium, niobium, tantalum, or niobium titanium nitride; and/or
b) a thickness of the superconducting material is greater than the London penetration depth of the superconducting material, optionally at least 50% greater.

14. A superconducting qubit comprising a capacitor and a Josephson junction, wherein:

the Josephson junction is connected to the capacitor;

the capacitor comprises two electrode structures;

the capacitor comprises two opposing surfaces, each opposing surface provided by a corresponding one of the electrode structures;

the capacitor is configured such that, when the superconducting qubit is placed in a vacuum, a region between the opposing surfaces is evacuated; and

each electrode structure comprises a dielectric material coated with a superconducting material such that:

the opposing surfaces are coated with the superconducting material; and

three mutually perpendicular lines can be drawn through the dielectric material, each line intersecting the superconducting material on two opposing sides of the electrode structure.

15. The superconducting qubit of any preceding claim, wherein a configuration of the capacitor is such that an energy relaxation lifetime of the qubit is at least $100\mu s$, optionally at least $200\mu s$, optionally at least $500\mu s$, optionally at least 1ms, optionally at least 2ms, optionally at least 4ms.

3

5

Fig. 1

9

7

100

5

7

Fig. 2

Fig. 3

Fig. 4

Electric field
energy density

$10^{-8}$

$10^{-9}$

$10^{-10}$

$10^{-11}$

$10^{-12}$

Fig. 5

Fig. 6

Fig. 7

Fig. 8

Fig. 9

Fig. 10

Fig. 11

Electric field
energy density

Fig. 12

Fig. 13

Fig. 14

Fig. 15

Fig. 16

Europäisches
Patentamt

European
Patent Office

Office européen
des brevets

## EUROPEAN SEARCH REPORT

**Application Number**

EP 23 21 9355

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | HAO DENG ET AL: "Titanium Nitride Film on Sapphire Substrate with Low Dielectric Loss for Superconducting Qubits", ARXIV.ORG, CORNELL UNIVERSITY LIBRARY, 201 OLIN LIBRARY CORNELL UNIVERSITY ITHACA, NY 14853, 7 May 2022 (2022-05-07), XP091222334, DOI: 10.48550/arXiv.2205.03528 | 1,2, 4-13,15 | INV. H10N69/00<br><br>ADD. G06N10/40 |
| A | * the whole document * | 3,14 | |
| | - - - - - | | |
| Y,D | ZEMLICKA M ET AL: "Compact vacuum gap transmon qubits: Selective and sensitive probes for superconductor surface losses", ARXIV.ORG, CORNELL UNIVERSITY LIBRARY, 201 OLIN LIBRARY CORNELL UNIVERSITY ITHACA, NY 14853, 28 June 2022 (2022-06-28), XP091258743, DOI: 10.48550/arXiv.2206.14104 | 1,2, 4-13,15 | |
| A | * the whole document * | 3,14 | |
| | - - - - - | | |

**TECHNICAL FIELDS SEARCHED (IPC)**

H10N
H01L
G06N

The present search report has been drawn up for all claims

| Place of search | Date of completion of the search | Examiner |
|---|---|---|
| Munich | 6 June 2024 | Krohns, Stephan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☒ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt
European
Patent Office
Office européen
des brevets

**LACK OF UNITY OF INVENTION**
**SHEET B**

Application Number

EP 23 21 9355

The Search Division considers that the present European patent application does not comply with the requirements of unity of invention and relates to several inventions or groups of inventions, namely:

1. claims: 1-15

   A superconducting qubit comprising a capacitor and a Josephson junction

   1.1. claims: 1-13 (completely); 15 (partially)

   The capacitor is configured in that the energy relaxation lifetime of the qubit is at least 100us.

   1.2. claims: 14 (completely); 15 (partially)

   The capacitor comprises a dielectric material coated with superconducting material which covers at least partially all sides of the dielectric material.
   - - -

Please note that all inventions mentioned under item 1, although not necessarily linked by a common inventive concept, could be searched without effort justifying an additional fee.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ZEMLICKA**. *Compact vacuum gap transmon qubits: Selective and sensitive probes for superconductor surface losses*, 2022
- **WANG, C.** ; **LI, X.** ; **XU, H. et al.** Towards practical quantum computers: transmon qubit with a lifetime approaching 0.5 milliseconds. *Quantum Inf*, 2022, vol. 8, 3
- **WANG**. *Surface participation and dielectric loss in superconducting qubits*, 2015
- **GAMBETTA**. *Investigating Surface Loss Effects in Superconducting Transmon Qubits*, 2017
- **MURRAY**. *Analytical Determination of Participation in Superconducting Coplanar Architectures*, 2018